# EUROPÄISCHE PATENTSCHRIFT

(11) **EP 2 462 633 B1**
(45) Veröffentlichungstag und Bekanntmachung des Hinweises auf die Patenterteilung: **05.09.2018**
(21) Anmeldenummer: 10742446.7
(22) Anmeldetag: 19.07.2010
(51) Int. Cl.: H01L 33/48, H01L 33/62, H01L 33/54, H01L 23/31, H01L 25/075

(54) **VERFAHREN ZUR HERSTELLUNG EINES OPTOELEKTRONISCHEN HALBLEITERBAUELEMENTS UND OPTOELEKTRONISCHES HALBLEITERBAUELEMENT**
METHOD FOR PRODUCING AN OPTOELECTRONIC SEMICONDUCTOR COMPONENT AND OPTOELECTRONIC SEMICONDUCTOR COMPONENT
PROCÉDÉ DE FABRICATION D'UN COMPOSANT SEMICONDUCTEUR OPTOÉLECTRONIQUE ET COMPOSANT SEMICONDUCTEUR OPTOÉLECTRONIQUE

(30) Priorität: 07.08.2009 DE 102009036621
(43) Veröffentlichungstag der Anmeldung: 13.06.2012
(73) Patentinhaber: OSRAM Opto Semiconductors GmbH, 93055 Regensburg (DE)
(72) Erfinder: WEIDNER, Karl, 81245 München (DE); WIRTH, Ralph, 93098 Mintraching - Auhof (DE); KALTENBACHER, Axel, 93098 Mintraching (DE); WEGLEITER, Walter, 93152 Nittendorf (DE); BARCHMANN, Bernd, 93059 Regensburg (DE); WUTZ, Oliver, 93049 Regensburg (DE); MARFELD, Jan, 93055 Regensburg (DE)
(74) Vertreter: Epping - Hermann - Fischer
(86) Internationale Anmeldenummer: PCT/EP2010/060434
(87) Internationale Veröffentlichungsnummer: WO 2011/015449

(56) Entgegenhaltungen:
- WO-A2-2009/075530
- WO-A2-2009/075753
- DE-A1- 10 245 930
- DE-A1-102007 030 129
- DE-A1-102011 080 458
- JP-A- 11 214 754
- JP-A- 2000 124 507
- US-A1- 2005 151 147

## Beschreibung

Die Druckschriften WO 2009/075753 A2 und WO 02/084749 beschreiben jeweils ein optoelektronisches Halbleiterbauteil.

Eine zu lösende Aufgabe besteht darin, ein vereinfachtes Herstellungsverfahren zur Herstellung eines optoelektronischen Halbleiterbauteils anzugeben. Eine weitere zu lösende Aufgabe besteht darin, ein optoelektronisches Halbleiterbauteil anzugeben, das besonderes einfach hergestellt werden kann.

Die Erfindung betrifft ein Verfahren gemäß Anspruch 1 sowie ein optoelektronisches Halbleiterbauteil gemäß Anspruch 7.

Es wird ein Verfahren zur Herstellung eines optoelektronischen Halbleiterbauteils angegeben. Bei dem optoelektronischen Halbleiterbauteil handelt es sich beispielsweise um eine Leuchtdiode, die zur Emission von elektromagnetischer Strahlung vorgesehen ist. Alternativ kann es sich bei dem optoelektronischen Halbleiterbauteil auch um eine Fotodiode handeln, die zur Detektion von elektromagnetischer Strahlung vorgesehen ist.

Bei dem Verfahren wird zunächst ein Träger bereitgestellt. Bei dem Träger handelt es sich um einen temporären Träger, der in einem abschließenden Verfahrensschritt wieder entfernt wird. Bei dem Träger kann es sich beispielsweise um eine Folie (englisch: Foil) eine Leiterplatte oder allgemein um eine Platte handeln, die mit einem Kunststoffmaterial, einem Metall, einem keramischen Material oder einem Halbleitermaterial gebildet ist.

Bei dem Verfahren wird zumindest ein optoelektronischer Halbleiterchip an einer Oberseite des Trägers auf dem Träger angeordnet. Bei dem optoelektronischen Halbleiterchip handelt es sich beispielsweise um einen Leuchtdiodenchip oder um einen Fotodiodenchip. Ferner kann es sich um einen Laserdiodenchip handeln. Der zumindest eine optoelektronische Halbleiterchip wird auf dem Träger vorzugsweise derart befestigt, dass sich eine mechanische Verbindung zwischen dem optoelektronischen Halbleiterchip und dem Träger ergibt, die später für den optoelektronischen Halbleiterchip zerstörungsfrei gelöst werden kann. Mit anderen Worten wird zwischen dem Halbleiterchip und dem Träger eine Opferschicht angeordnet. Der optoelektronische Halbleiterchip kann beispielsweise auf dem Träger mittels eines Klebstoffs befestigt werden.

Bevorzugt wird eine Vielzahl von optoelektronischen Halbleiterchips auf dem Träger befestigt. Bei der Anordnung aus Träger und der Vielzahl von optoelektronischen Halbleiterchips handelt es sich dann um einen so genannten Kunstwafer, bei dem eine Vielzahl - vorzugsweise gleichartiger optoelektronischer Halbleiterchips - auf einem gemeinsamen Träger angeordnet sind.

Bei dem Verfahren wird der zumindest eine optoelektronische Halbleiterchip - vorzugsweise die Vielzahl von optoelektronischen Halbleiterchips - mit einem Formkörper umformt, wobei der Formkörper alle Seitenflächen des zumindest einen optoelektronischen Halbleiterchips bedeckt.

Mit anderen Worten wird der zumindest eine optoelektronische Halbleiterchip vom Formkörper umhüllt. Das Umformen oder Umhüllen kann beispielsweise mittels Spritzens, Gießens, Druckens, Auflaminieren einer Folie, oder dergleichen erfolgen. Der Formkörper ist aus einem mechanisch stabilisierenden Material gebildet, wie beispielsweise einem Kunststoff, einem niederschmelzenden Glas oder einer niederschmelzenden Glaskeramik. Der Formkörper kann beispielsweise Epoxidharz, Silikon, Epoxid-Silikonhybrid-Material, Glas oder Glaskeramik enthalten oder aus einem dieser Materialien bestehen.

Der Formkörper wird derart auf dem Träger aufgebracht, dass er die dem zumindest einen optoelektronischen Halbleiterchip zugewandte Oberfläche des Trägers bedeckt und mit dieser Oberfläche in direktem Kontakt steht. Ferner steht der Formkörper mit den Seitenflächen, die zum Beispiel quer oder senkrecht zur Oberfläche des Trägers verlaufen, zumindest stellenweise in direktem Kontakt. Die Halbleiterchips sind dabei nur bis zu einer bestimmten Höhe an ihren Seitenflächen vom Formkörper bedeckt und Teile des zumindest einen Halbleiterchips ragen aus dem Formkörper heraus, so dass die Seitenflächen des zumindest einen optoelektronischen Halbleiterchips stellenweise frei vom Formkörper sind.

Bei dem Verfahren wird der Träger entfernt. Das heißt, nach dem Umformen des zumindest einen optoelektronischen Halbleiterchips wird der Träger vom Verbund aus Formkörper und optoelektronischem Halbleiterchip entfernt. Das Entfernen kann beispielsweise durch Erwärmen oder Dünnen des Trägers erfolgen. Das Erwärmen kann beispielsweise mittels eines Laserstrahls erfolgen. Das Dünnen kann zum Beispiel durch Zurückschleifen des Trägers erfolgen. Ferner ist es möglich, dass das Entfernen durch chemisches Ab- bzw. Ablösen des Trägers bzw. der ggf. auf dem Träger vorhanden Haftschicht erfolgt. Nach dem Entfernen des Trägers ist die ursprünglich dem Träger zugewandte Unterseite des zumindest einen optoelektronischen Halbleiterchips frei zugänglich. Bei der Unterseite kann es sich auch um die Abstrahlseite des Halbleiterchips handeln, durch die im Betrieb des Halbleiterchips Strahlung aus diesem austritt. Mit anderen Worten wird der Halbleiterchip dann "face-down" auf den Träger aufgebracht. Alle Seitenflächen des zumindest einen optoelektronischen Halbleiterchips sind zumindest stellenweise vom Formkörper bedeckt. Das heißt, nach dem Entfernen des Trägers stellt der Formkörper einen mechanisch stabilisierenden Körper dar, der den zumindest einen optoelektronischen Halbleiterchip an seinen Seitenflächen umgibt und - falls vorhanden - eine Vielzahl von optoelektronischen Halbleiterchips miteinander verbindet.

Das Verfahren zur Herstellung eines optoelektronischen Halbleiterbauelements umfasst die folgenden Schritte:
- Bereitstellen eines Trägers,
- Anordnen zumindest eines optoelektronischen Halbleiterchips an einer Oberseite des Trägers,
- Umformen des zumindest einen optoelektronischen Halbleiterchips mit einem Formkörper, wobei der Formkörper alle Seitenflächen des zumindest einen optoelektronischen Halbleiterchips bedeckt, und
- Entfernen des Trägers.

Die beschriebenen Verfahrensschritte werden dabei in der angegebenen Reihenfolge durchgeführt.

Gemäß zumindest einer Ausführungsform des Verfahrens wird eine Vielzahl von optoelektronischen Halbleiterchips an der Oberseite des Trägers angeordnet, wobei jeder der Halbleiterchips im Betrieb zur Erzeugung von elektromagnetischer Strahlung eines Wellenlängenbereichs mit einer dem Halbleiterchip zugeordneten Peak-Wellenlänge vorgesehen ist. Das heißt, jeder der Halbleiterchips ist zur Erzeugung von elektromagnetischer Strahlung geeignet. Der Halbleiterchip erzeugt im Betrieb dabei elektromagnetische Strahlung in einem bestimmten Wellenlängenbereich. Die erzeugte elektromagnetische Strahlung weist im Wellenlängenbereich bei einer bestimmten Wellenlänge - der Peak-Wellenlänge - ein Maximum auf. Mit anderen Worten ist die Peak-Wellenlänge die dominante Wellenlänge der vom Halbleiterchip im Betrieb erzeugten elektromagnetischen Strahlung.

Die Peak-Wellenlänge eines jeden der Halbleiterchips weicht dabei von einem Mittelwert der Peak-Wellenlängen aller optoelektronischen Halbleiterchip um höchstens +/- 2 % ab. Das heißt, bei den optoelektronischen Halbleiterchips handelt es sich um optoelektronische Halbleiterchips, die elektromagnetische Strahlung bei gleichen oder ähnlichen Wellenlängen emittieren. Vorzugsweise weicht die Peak-Wellenlänge eines jeden der Halbleiterchips von einem Mittelwert der Peak-Wellenlängen aller optoelektronischen Halbleiterchips höchstens um +/- 1 %, besonders bevorzugt um höchstens +/- 0,5 % ab.

Mit anderen Worten sind die auf dem Träger angeordneten optoelektronischen Halbleiterchips hinsichtlich ihrer Emissionswellenlänge vorsortiert. Es werden solche optoelektronischen Halbleiterchips gemeinsam auf dem Träger angeordnet, die sich in ihrer Peak-Wellenlänge kaum oder gar nicht voneinander unterscheiden.

Beispielsweise werden die optoelektronischen Halbleiterchips nach ihrer Herstellung hinsichtlich ihrer Peak-Wellenlänge sortiert (so genanntes binning). Diejenigen optoelektronischen Halbleiterchips, die bei dieser Sortierung in eine gemeinsame Gruppe eingeteilt werden, werden auf dem Träger angeordnet.

Gemäß zumindest einer Ausführungsform des Verfahrens wird den optoelektronischen Halbleiterchips vor oder nach dem Umformen eine gemeinsame Leuchtstoffschicht an ihrer Oberseite oder ihrer Unterseite nachgeordnet. "Gemeinsame Leuchtstoffschicht" heißt dabei, dass sämtlichen optoelektronischen Halbleiterchips eine Leuchtstoffschicht mit gleichen oder ähnlichen Eigenschaften nachgeordnet wird. Das heißt, die Leuchtstoffschicht aller optoelektronischen Halbleiterchips besteht beispielsweise aus dem gleichen Material und weist die gleiche Dicke auf.

Die Leuchtstoffschicht enthält oder besteht aus einem Leuchtstoff, der zur Absorption der von den Halbleiterchips im Betrieb erzeugten elektromagnetischen Strahlung vorgesehen ist und der elektromagnetische Strahlung in einem anderen Wellenlängenbereich als die optoelektronischen Halbleiterchips re-emittiert. Beispielsweise erzeugen die optoelektronischen Halbleiterchips im Betrieb blaues Licht und vom Leuchtstoff der Leuchtstoffschicht wird gelbes Licht re-emittiert, welches sich mit dem blauen Licht zu weißem Licht mischt. Die Leuchtstoffschicht kann beispielsweise in Form von Leuchtstoffpartikeln aufgebracht werden, die in einem Matrixmaterial wie beispielsweise Silikon oder Keramik eingebracht sind. Ferner kann die Leuchtstoffschicht als Keramikplättchen, das den Leuchtstoff enthält oder aus einem keramischen Leuchtstoff besteht, auf die dem Träger abgewandte Oberfläche der Halbleiterchips, aufgebracht werden. Dabei ist es möglich, dass die Leuchtstoffschicht direkt auf die dem Träger abgewandte Oberfläche der optoelektronischen Halbleiterchips aufgebracht wird.

Besonders bevorzugt handelt es sich bei den optoelektronischen Halbleiterchips, wie soeben beschrieben, um ähnliche optoelektronische Halbleiterchips, die sich hinsichtlich ihrer Peak-Wellenlänge kaum oder gar nicht voneinander unterscheiden. Vorteilhaft kann diesen ähnlichen optoelektronischen Halbleiterchips eine gemeinsame Leuchtstoffschicht nachgeordnet werden. Aufgrund der Ähnlichkeit der optoelektronischen Halbleiterchips und der gemeinsamen Leuchtstoffschicht emittieren die derart hergestellten optoelektronischen Halbleiterchips im Betrieb Mischlicht mit ähnlichen oder gleichen Eigenschaften. Anders, als bei einer sonst üblichen Herstellung von optoelektronischen Halbleiterbauteilen muss also nicht jedem optoelektronischen Halbleiterchip eine passende Leuchtstoffschicht nachgeordnet werden, so dass sich eine gewünschte Mischstrahlung aus der vom optoelektronischen Halbleiterchip direkt emittierten elektromagnetischen Strahlung und der von der Leuchtstoffschicht re-emittierten elektromagnetischen Strahlung einstellt.

Bei dem Verfahren wird die dem Träger abgewandte Oberseite des zumindest einen Halbleiterchips vom Formkörper freigelegt oder sie bleibt frei vom Formkörper. Das heißt, der Formkörper wird entweder so aufgebracht, dass die dem Träger abgewandte Oberfläche des zumindest einen Halbleiterchips nicht mit dem Material des Formkörpers bedeckt wird. Alternativ kann der Formkörper nach dem Aufbringen des Formkörpers von der Oberseite der Halbleiterchips wieder entfernt werden. Auf die vom Formkörper freie Oberfläche kann dann beispielsweise die Leuchtstoffschicht aufgebracht werden.

Es ist jedoch auch möglich, dass die Halbleiterchips mit ihrer Abstrahlseite auf den Träger befestigt werden. Bei Entfernen des Trägers wird die dem Träger zugewandte Oberfläche - also die Unterseite - freigelegt. Bei dieser Variante des Verfahrens kann sich zumindest ein Anschlusskontakt auf der Abstrahlseite eines jeden der Halbleiterchips befinden.

Gemäß zumindest einer Ausführungsform des Verfahrens wird vor oder nach dem Umformen für jeden Halbleiterchip zumindest eine Durchkontaktierung mit einem elektrisch leitenden Material erzeugt. Die Durchkontaktierung ist dabei lateral beabstandet zum zugeordneten Halbleiterchip angeordnet. Das heißt, in einer Richtung, die beispielsweise parallel zur Oberfläche des Trägers verläuft, die den Halbleiterchips zugeordnet ist, wird im Abstand zum Halbleiterchip eine Durchkontaktierung erzeugt. Die Durchkontaktierung durchdringt den Formkörper dabei vollständig und erstreckt sich von einer Oberseite des Formkörpers zu einer Unterseite des Formkörpers. Nach dem Abschluss des Verfahrens, das heißt nach Entfernen des Trägers, ist die Durchkontaktierung zumindest an der Unterseite des Formkörpers frei zugänglich. An der Oberseite des Formkörpers kann die Durchkontaktierung von der Leuchtstoffschicht bedeckt sein.

Vor dem Umformen des Formkörpers kann die Durchkontaktierung beispielsweise mittels Kontaktstifte erzeugt werden, die vor dem Umformen an der Oberseite des Trägers zwischen den Halbleiterchips angeordnet werden. Die Kontaktstifte sind dabei aus einem elektrisch leitenden Material wie beispielsweise Kupfer gebildet. Die Kontaktstifte können dabei auch einstückig mit dem Träger ausgebildet sein. Das heißt, als Träger wird ein Substrat mit vorhandenen Durchkontaktierungen genutzt. Ferner kann es sich bei dem Träger um ein Stanzgitter handeln.

Alternativ ist es möglich, dass die Durchkontaktierungen durch das Erzeugen von Ausnehmungen im Formkörper nach dem Umformen des Halbleiterchips erzeugt werden. Beispielsweise können durch Laserbohren oder andere Arten des Materialabtrags Löcher im Formkörper erzeugt werden, die den Formkörper vollständig durchdringen und sich von seiner Oberseite zu seiner Unterseite erstrecken. Diese Löcher werden dann mit einem leitfähigen Material gefüllt. Bei dem leitfähigen Material kann es sich beispielsweise um eine Galvanik handeln, ein Lotmaterial oder einen Leitkleber.

Gemäß zumindest einer Ausführungsform des Verfahrens wird zwischen der Durchkontaktierung und dem zugeordneten Halbleiterchip eine elektrisch leitende Verbindung erzeugt. Die elektrisch leitende Verbindung ist dabei elektrisch leitend mit der dem Träger abgewandten Oberfläche an der Oberseite des Halbleiterchips verbunden und erstreckt sich entlang der Oberseite des Formkörpers. Die elektrisch leitende Verbindung steht beispielsweise mit einem Bondpad an der Oberseite des zugeordneten Halbleiterchips in elektrisch leitendem Kontakt und erstreckt sich bis zur Durchkontaktierung. Die Verbindung erstreckt sich dabei an der Oberseite des Formkörpers entweder auf der Außenfläche des Formkörpers oder dicht unterhalb der Außenfläche des Formkörpers. Die elektrisch leitende Verbindung kann mittels Sputtern, Fotolithographie, Galvanik und/oder Rückätzen erzeugt werden. Ferner ist es möglich, zur Erzeugung der elektrisch leitenden Verbindung Isolationsmaterial und Metall aufzudrucken, mittels eines Sinterverfahrens als Metallpaste aufzubringen (insbesondere, wenn der Formkörper aus einem keramischen Material gebildet ist), als Leitkleber aufzubringen oder dergleichen. So ist es beispielsweise auch möglich, dass die elektrisch leitenden Verbindungen mittels eines Spritzgussverfahrens aufgebracht werden. Das heißt, die elektrisch leitenden Verbindungen werden dann nach Art eines "Molded interconnected devices" (MID, deutsch: Spritzgegossene Schaltungsträger) aufgebracht.

Die Erzeugung von Durchkontaktierungen und zugeordneten elektrisch leitenden Verbindungen ist vorteilhaft, wenn die optoelektronischen Halbleiterchips an ihrer Oberseite und der Oberseite abgewandten Unterseite elektrisch leitende Kontaktstellen aufweisen. Alternativ ist die Verwendung von Flip-Chip-Halbleiterchips möglich, die elektrische Kontaktstellen nur an einer Seite, entweder der Unterseite oder der Oberseite, aufweisen. In diesem Fall kann die Durchkontaktierung durch den Formkörper entfallen.

Es wird ferner ein optoelektronisches Halbleiterbauteil angegeben. Das optoelektronische Halbleiterbauteil ist vorzugsweise mittels einem der hier beschriebenen Verfahren herstellbar. Das heißt, sämtliche für das Verfahren offenbarte Merkmale sind auch für das optoelektronische Halbleiterbauteil offenbart und umgekehrt.

Bei dem optoelektronischen Halbleiterbauteil umfasst das optoelektronische Halbleiterbauteil einen optoelektronischen Halbleiterchip, dessen Seitenflächen von einem Formkörper bedeckt sind. Die Seitenflächen sind dabei jene Flächen, die quer zu der Außenfläche des optoelektronischen Halbleiterchips an seiner Oberseite und seiner Unterseite verlaufen und diese Außenflächen miteinander verbinden. Die Seitenflächen sind nur bis zu einer bestimmten Höhe vom Formkörper bedeckt. Beispielsweise kann es sich beim optoelektronischen Halbleiterchip um einen Halbleiterchip handeln, bei dem Halbleiterschichten epitaktisch auf ein Substrat abgeschieden sind. Es ist dann möglich, dass die Seitenflächen des Halbleiterchips derart bedeckt sind, dass die epitaktisch hergestellten Schichten frei vom Formkörper sind. Die epitaktisch hergestellten Schichten können dann mittels eines weiteren Materials, zum Beispiel über einen Druckprozess, bedeckt werden oder bleiben frei.

Bei dem optoelektronischen Halbleiterbauteil umfasst das optoelektronische Halbleiterbauteil zumindest eine Durchkontaktierung, die ein elektrisch leitendes Material umfasst. Bei dem elektrisch leitenden Material handelt es sich beispielsweise um ein Metall oder einen elektrisch leitfähigen Kleber.

Bei dem optoelektronischen Halbleiterbauteilumfasst das Bauteil eine elektrisch leitende Verbindung, die elektrisch leitend mit dem Halbleiterchip und der Durchkontaktierung verbunden ist. Die elektrisch leitende Verbindung ist beispielsweise mit einem Metall oder einem elektrisch leitfähigen Klebstoff gebildet.

Bei dem optoelektronischen Halbleiterbauteil ist die Durchkontaktierung lateral beabstandet zum Halbleiterchip angeordnet. Die laterale Richtung ist dabei diejenige Richtung, die quer oder senkrecht zu den Seitenflächen des optoelektronischen Halbleiterchips verläuft. Das heißt, die Durchkontaktierung ist seitlich vom Halbleiterchip angeordnet und verläuft beispielsweise parallel oder im Wesentlichen parallel zu einer Seitenfläche des optoelektronischen Halbleiterchips. Die Durchkontaktierung durchdringt den Formkörper dabei vorzugsweise vollständig und erstreckt sich von einer Oberseite des Formkörpers zu einer Unterseite des Formkörpers. Dabei ist es möglich, dass die Durchkontaktierung an der Oberseite und der Unterseite des Formkörpers frei zugänglich ist.

Bei dem optoelektronischen Halbleiterbauteilerstreckt sich die elektrisch leitende Verbindung an der Oberseite des Formkörpers. Das heißt, die elektrisch leitende Verbindung verbindet den Halbleiterchip mit der Durchkontaktierung und verläuft dabei zwischen Halbleiterkörper und Durchkontaktierung an der Oberseite des Formkörpers. Die elektrisch leitende Verbindung kann dabei auf einer Außenfläche des Formkörpers angeordnet sein.

Bei dem optoelektronischen Halbleiterbauteil umfasst das optoelektronische Halbleiterbauteil einen optoelektronischen Halbleiterchip, dessen Seitenflächen von einem Formkörper bedeckt sind. Ferner umfasst das optoelektronische Halbleiterbauteil zumindest eine Durchkontaktierung, die ein elektrisch leitendes Material umfasst und eine elektrisch leitende Verbindung, die elektrisch leitend mit dem Halbleiterchip und der Durchkontaktierung verbunden ist. Die Durchkontaktierung ist dabei lateral beabstandet zum Halbleiterchip angeordnet und durchdringt den Formkörper vollständig. Die Durchkontaktierung erstreckt sich von einer Oberseite des Formkörpers zu einer Unterseite des Formkörpers und die elektrisch leitende Verbindung erstreckt sich an der Oberseite des Formkörpers vom Halbleiterchip zur Durchkontaktierung.

Bei dem optoelektronischen Halbleiterbauteil ist der Formkörper optisch reflektierend ausgebildet. Dies kann beispielsweise dadurch erreicht sein, dass elektromagnetische Strahlung, insbesondere Licht reflektierende Partikel in ein Matrixmaterial des Formkörpers eingebracht sind. Elektromagnetische Strahlung, die an den Seitenflächen des optoelektronischen Halbleiterchips austritt, kann dann vom Formkörper reflektiert werden. Der Formkörper bedeckt in diesem Fall den optoelektronischen Halbleiterchip an dessen Oberseite zumindest stellenweise nicht. Die Partikel sind zum Beispiel mit zumindest einem der folgenden Materialien gebildet oder enthalten zumindest eines der folgenden Materialien: TiO₂, BaSO₄, ZnO, AlₓO_{y}. Als besonders vorteilhaft erweist es sich, wenn der Formkörper Silikon enthält oder aus Silikon besteht und die Partikel aus Titanoxid bestehen.

Vorzugsweise sind die Partikel in einer solchen Konzentration in den Formkörper eingebracht, dass dieser weiß erscheint.

Ferner ist es möglich, dass der Formkörper strahlungsdurchlässig ausgebildet ist. Dies ist besonders vorteilhaft für optoelektronische Halbleiterchips, die einen großen Anteil ihrer elektromagnetischen Strahlung durch die Seitenflächen emittieren.

Gemäß zumindest einer Ausführungsform des optoelektronischen Halbleiterbauteils umfasst das Halbleiterbauteil eine Vielzahl von Halbleiterchips, die mittels elektrisch leitender Verbindungen, die sich an einer Oberseite des Formkörpers erstrecken, elektrisch leitend miteinander verbunden sind. Beispielsweise können die Halbleiterchips über die elektrisch leitenden Verbindungen in Reihe oder parallel geschaltet sein. Die Halbleiterchips sind jeweils an ihren Seitenflächen vom Formkörper bedeckt. Der Formkörper stellt das Verbindungsmaterial dar, mit dem die elektrisch leitenden Halbleiterchips zum optoelektronischen Halbleiterbauteil verbunden sind.

Im Folgenden werden das hier beschriebene Verfahren sowie das hier beschriebene optoelektronische Halbleiterbauteil anhand von Ausführungsbeispielen und den dazugehörigen Figuren näher erläutert.
- Die Figuren 1 bis 3: zeigen Ausführungsbeispiele des hier beschriebenen Verfahrens anhand schematischer Schnittdarstellungen.
- Die Figuren 4 und 5: zeigen schematische Darstellungen von Ausführungsbeispielen hier beschriebener optoelektronischer Halbleiterbauteile.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

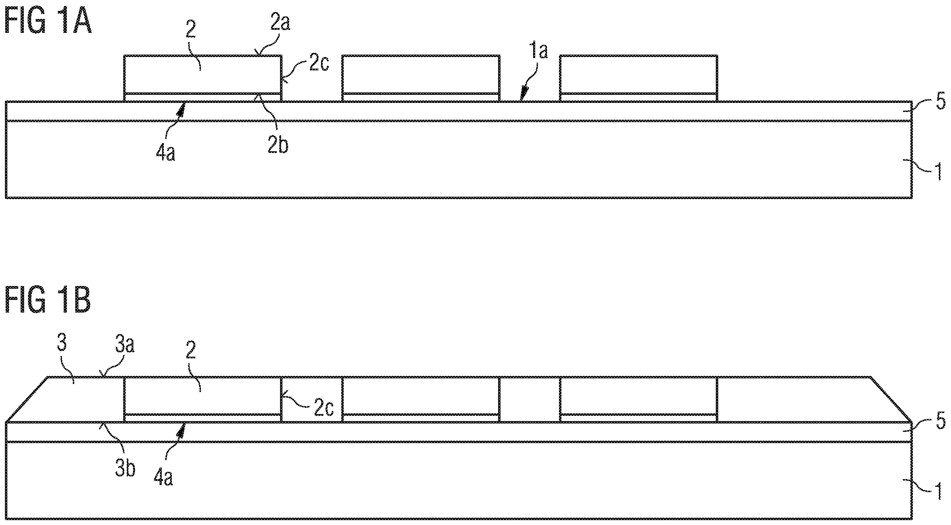

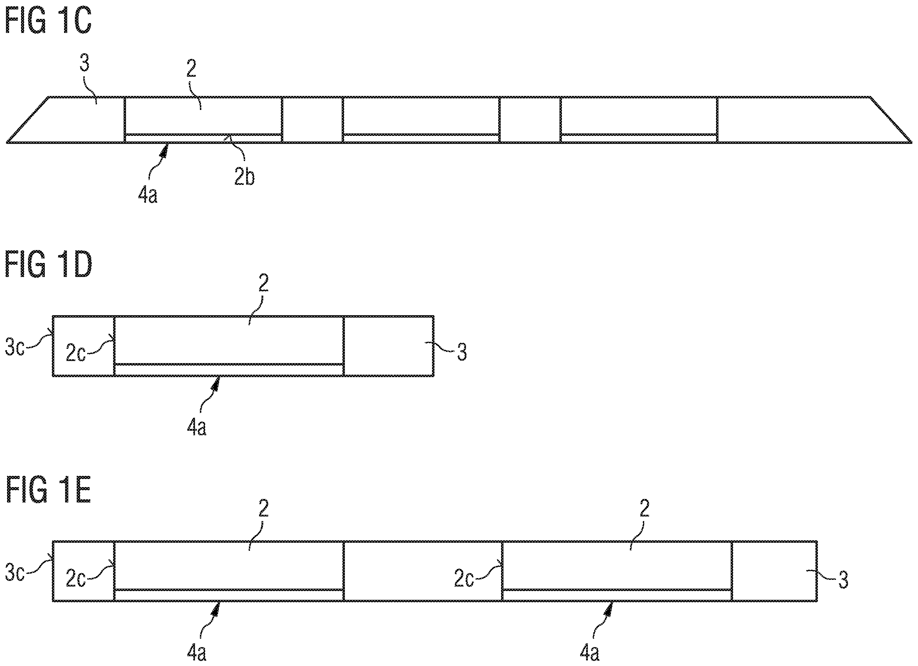

Anhand der schematischen Schnittdarstellung der Figur 1A ist ein erster Verfahrensschritt eines hier beschriebenen Verfahrens zur Herstellung eines optoelektronischen Halbleiterbauteils näher erläutert. Bei dem Verfahren wird zunächst ein Träger 1 bereitgestellt. Bei dem Träger 1 handelt es sich beispielsweise um einen Träger, der mit einem Metall wie Kupfer oder Aluminium, mit einer Keramik, mit einem Halbleitermaterial oder einem Kunststoff gebildet ist. An der Oberseite 1a des Trägers 1 ist eine Vielzahl von optoelektronischen Halbleiterchips 2 angeordnet, bei denen es sich vorliegend um Leuchtdiodenchips handelt. Die Halbleiterchips 2 sind mittels eines Verbindungsmittels 5 am Träger 1 befestigt. Bei dem Verbindungsmittel 5 handelt es sich beispielsweise um einen Klebstoff. Die Unterseite 2b der Halbleiterchips 2 ist dabei der Oberseite 1a des Trägers 1 zugewandt. An der Unterseite 2b der Halbleiterchips 2 befindet sich eine Kontaktstelle 4a, die zur elektrischen Kontaktierung des Halbleiterchips 2 vorgesehen ist. Beispielsweise handelt es sich bei der Kontaktstelle 4a um eine Metallisierung an der Unterseite 2b des Halbleiterchips 2. Eine Strahlungsaustrittsfläche des Halbleiterchips 2 kann die Seitenflächen 2c und die Außenfläche an der Oberseite 2a umfassen.

Es ist dabei möglich, dass sich eine Kontaktstelle 4a an der Oberseite 2a und eine Kontaktstelle 4b an der Unterseite 2b befindet. Ferner können sich beide Kontaktstellen 4a, 4b an der selben Seite befinden. Ferner ist es möglich, dass es sich bei der Unterseite 2b oder der Oberseite 2a um die Abstrahlseite des Halbleiterchips 2 handelt. Das heißt, die Strahlungsaustrittsfläche des Halbleiterchips 2 kann die Seitenflächen 2c und die Außenfläche an der Oberseite 2a und / oder der Unterseite 2b umfassen.

In Verbindung mit der Figur 1B ist ein weiterer Verfahrensschritt erläutert. In diesem Verfahrensschritt wird ein Formkörper 3 beispielsweise durch Aufspritzen einer Formmasse derart aufgebracht, dass die Seitenflächen 2c der Halbleiterchips 2 vom Formkörper bedeckt sind und der Formkörper die Halbleiterchips 2 miteinander verbindet. Die Unterseite 3b des Formkörpers steht dabei in direktem Kontakt mit dem Träger 1 oder dem Verbindungsmittel 5 an der Oberseite 1a des Trägers 1. Der Formkörper 3 bedeckt - anders als in der Figur 1B dargestellt - die Seitenflächen 2c der Halbleiterchips 2 nur bis zu einer bestimmten Höhe und die Halbleiterchips 2 überragen den Formkörper 3 an dessen Oberseite 3a.

Der Formkörper 3 kann strahlungsdurchlässig, zum Beispiel transparent, strahlungsabsorbierend oder reflektierend ausgebildet sein.

Im in Verbindung mit der Figur 1C erläuterten Verfahrensschritt wird der Träger 1 samt der optional vorhandenen Verbindungsmittelschicht 5 vom Formkörper und den Halbleiterchips 2 gelöst. Es verbleibt ein Verbund aus Halbleiterchips 2, die mittels des Formkörpers 3 miteinander verbunden sind. An der Unterseite 2b der Halbleiterchips 2 ist die Kontaktstelle 4a und - im falle einer "face-down" - Anordnung auch die Strahlungsdurchtrittsfläche - freigelegt.

In einem weiteren Verfahrensschritt, schematisch dargestellt in der Figur 1D, kann der Verbund der Halbleiterchips 2 zu einzelnen optoelektronischen Halbleiterbauteilen vereinzelt werden, die einen oder mehrere Halbleiterchips 2 umfassen. Durch das Vereinzeln werden Seitenflächen 3c des Formkörpers erzeugt, welche Spuren eines Materialabtrages aufweisen. Beispielsweise können die Seitenflächen 3c Sägerillen oder Schleifspuren aufweisen, die vom Vereinzeln des Formkörpers 3 herrühren. Jeder der Halbleiterchips 2 ist an seinen Seitenflächen 2c vom Formkörper 3 zumindest stellenweise bedeckt.

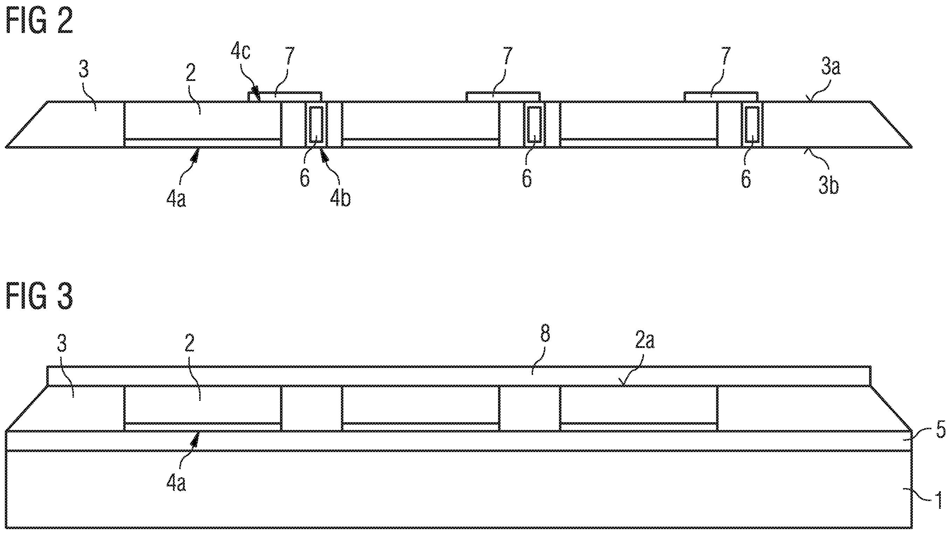

Anhand der schematischen Schnittdarstellung der Figur 2 ist ein weiterer Verfahrensschritt erläutert, der vor oder nach dem Umformen der Halbleiterchips 2 mit der Formmasse und vor oder nach dem Entfernen des Trägers erfolgen kann. In diesem Verfahrensschritt werden Durchkontaktierungen 6 aus einem elektrisch leitenden Material erzeugt, die den Formkörper 3 von dessen Oberseite 3a zu dessen Unterseite 3b durchdringen. Die Durchkontaktierungen 6 sind lateral beabstandet zu den Halbleiterkörpern 2 angeordnet. Jedem Halbleiterkörper 2 ist vorzugsweise eine Durchkontaktierung zugeordnet. Dabei kann die Zuordnung auch eindeutig sein. Ferner ist es möglich, dass eine Durchkontaktierung 6 für mehrere Halbleiterchips 2 vorhanden ist. Nach dem Erzeugen der Durchkontaktierung 6 wird eine elektrisch leitende Verbindung 7 an der Oberseite 3a vorliegend auf der Oberfläche des Formkörpers 3 ausgebildet, die eine Kontaktstelle 4c des Halbleiterchips 2 elektrisch leitend mit der Durchkontaktierung 6 verbindet. An der Unterseite des Formkörpers 3b sind die Durchkontaktierungen 6 frei zugänglich und bilden dort eine Kontaktstelle 4b für das Halbleiterbauteil.

Anhand der Figur 3 ist in einer schematischen Schnittdarstellung ein weiterer Verfahrensschritt erläutert, der nach dem Aufbringen des Formkörpers erfolgen kann. In diesem Verfahrensschritt wird eine Leuchtstoffschicht 8 an der Oberseite des Formkörpers 3 auf die Halbleiterchips 2 an ihrer Oberseite 2a aufgebracht. Die Leuchtstoffschicht 8 kann dabei über sämtliche Halbleiterchips 2 durchgehend ausgebildet sein, wie dies in der Figur 3 dargestellt ist. Ferner ist es möglich, dass auf jedem Halbleiterchip 2 eine eigene Leuchtstoffschicht aufgebracht sein kann. Dies kann dann auch vor dem Aufbringen der Formmasse erfolgen. Bei den optoelektronischen Halbleiterchips handelt es sich im Ausführungsbeispiel der Figur 3 vorzugsweise um Leuchtdiodenchips mit ähnlicher oder gleicher Abstrahlcharakteristik, das heißt, mit ähnlicher oder gleicher Peak-Wellenlänge wie weiter oben beschrieben. Auf die Halbleiterchips 2 ist eine einheitliche Leuchtstoffschicht 8 aufgebracht. Es resultieren optoelektronische Halbleiterbauteile mit ähnlichen oder gleichen Abstrahlcharakteristiken. Beispielsweise erzeugen die Halbleiterbauteile im Betrieb weißes Licht mit ähnlichem oder gleichem Farbort und/oder mit ähnlicher oder gleicher Farbtemperatur.

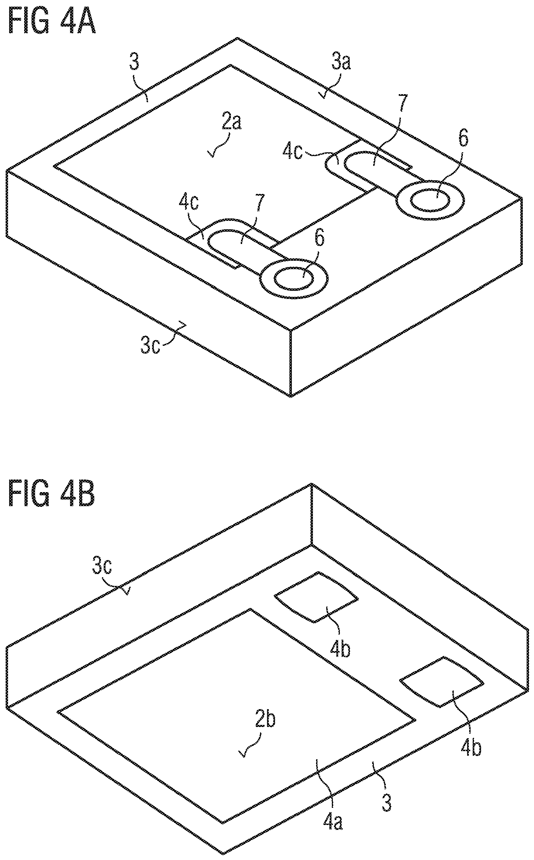

Die Figuren 4A und 4B zeigen Ansichten eines hier beschriebenen optoelektronischen Halbleiterbauteils in einer schematischen Perspektivdarstellung. Die Figur 4A zeigt das Halbleiterbauteil von der Oberseite 2a des Halbleiterchips 2 her. Das Halbleiterbauteil umfasst genau einen Halbleiterchip 2, der an seinen Seitenflächen 2c von der Formmasse 3 umgeben ist. Durch die Formmasse 3 sind Durchkontaktierungen 6 hin durchgeführt, die mittels elektrisch leitenden Verbindungen 7 mit Kontaktstellen 4c an der Oberseite 2a des Halbleiterchips 2 verbunden sind. An der Unterseite des Halbleiterbauteils, siehe die Figur 4B, ist eine Kontaktstelle 4a ausgebildet, mittels der der Halbleiterchip 2 beispielsweise p-seitig kontaktiert wird. Die n-seitige Kontaktierung erfolgt dann mittels der Kontaktstellen 4b, die durch die Durchkontaktierungen 6 gebildet sind. Zwischen den Durchkontaktierungen 6 und dem Halbleiterchip 2 ist ebenfalls der Formkörper 3 angeordnet, der die Durchkontaktierungen 6 vom Halbleiterchip 2 elektrisch isoliert.

Alternativ zum gezeigten Ausführungsbeispiel kann es sich beim Halbleiterchip 2 auch um einen Halbleiterchip handeln, bei dem beispielsweise n- und p-seitige Kontakte gemeinsam an der Unterseite 2b des Halbleiterchips angeordnet sind. In diesem Fall kann auf die Durchkontaktierungen 6 verzichtet werden.

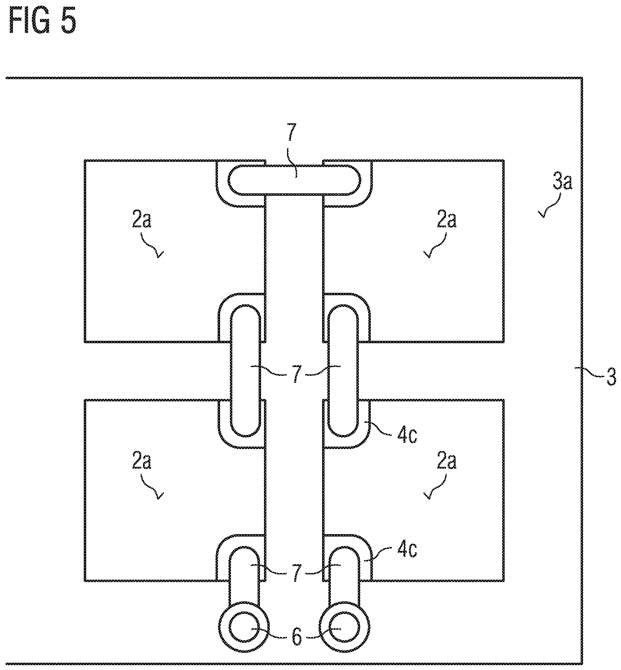

Die Figur 5 zeigt anhand einer schematischen Draufsicht ein weiteres Ausführungsbeispiel eines hier beschriebenen Halbleiterbauteils. In diesem Ausführungsbeispiel umfasst das Halbleiterbauteil vier Halbleiterchips 2, die mittels des Formkörpers 3 miteinander verbunden sind. Die Halbleiterchips 2 sind mittels elektrisch leitender Verbindungen 7, die an der Oberseite 3a des Formkörpers 3 angeordnet sind und beispielsweise auf der Außenfläche des Formkörpers verlaufen, elektrisch leitend miteinander verbunden. Vorliegend sind die Halbleiterchips über die elektrisch leitenden Verbindungen 7 in Reihe geschaltet und werden über Kontaktstellen 4b, die durch die Durchkontaktierungen 6 gebildet sind, sowie Kontaktstellen 4a elektrisch kontaktiert.

Das hier beschriebene Verfahren und die hier beschriebenen Halbleiterbauteile zeichnen sich unter anderem durch folgende Vorteile aus: Eine Entwärmung der Halbleiterbauteile kann ganzflächig über die gesamte Unterseite 2b der Halbleiterchips 2 erfolgen.

Über die Durchkontaktierungen 6 ist eine Flip-Chip-Kontaktierung des Halbleiterbauteils möglich. Das heißt, ein Bonddraht, der mechanisch anfällig ist, kann entfallen. Aufgrund der Tatsache, dass eine Vielzahl von Halbleiterchips 2 gleichzeitig mit dem Formkörper 3 umgeben werden können, handelt es sich um ein besonders Kosten sparendes Verfahren.

Das Vorsortieren der optoelektronischen Halbleiterchips beispielsweise hinsichtlich ihrer Peak-Wellenlänge, ermöglicht das gleichzeitige Aufbringen einer gemeinsamen Leuchtstoffschicht 8 auf alle Halbleiterchips, die sich dann durch ähnliche oder gleiche Abstrahlcharakteristiken auszeichnen.

Ferner kann mittels des Verfahrens flexibel ein Halbleiterbauteil mit einer fast beliebigen Anzahl von Halbleiterchips 2 erzeugt werden. Die Flächennutzung des Halbleiterbauteils ist optimal.

Diese Patentanmeldung beansprucht die Priorität der deutschen Patentanmeldung 10 2009 036 621.0.

## Patentansprüche

1. Verfahren zur Herstellung eines optoelektronischen Halbleiterbauteils mit den folgenden Schritten:
- Bereitstellen eines Trägers (1),
- Anordnen zumindest eines optoelektronischen Halbleiterchips (2) an einer Oberseite (1a) des Trägers (1),
- Umformen des zumindest einen optoelektronischen Halbleiterchips (2) mit einem Formkörper (3), wobei der Formkörper (3) alle Seitenflächen (2c) des zumindest einen optoelektronischen Halbleiterchips (2) bedeckt und
wobei die dem Träger (1) abgewandte Oberfläche an der Oberseite (2a) und die dem Träger zugewandte Oberfläche an der Unterseite (2b) des zumindest einen Halbleiterchips (2) frei vom Formkörper (3) bleibt,
- Entfernen des Trägers (1), wobei
- der Formkörper (3) ein Matrixmaterial umfasst und Licht reflektierende Partikel in das Matrixmaterial eingebracht sind, sodass der Formkörper (3) weiß erscheint,
- die Verfahrensschritte in der angegebenen Reihenfolge durchgeführt werden, und
- der zumindest eine optoelektronische Halbleiterchip (2) nur bis zu einer bestimmten Höhe an seinen Seitenflächen (2c) vom Formkörper (3) bedeckt ist und Teile des zumindest einen Halbleiterchips (2) aus dem Formkörper (3) herausragen.

2. Verfahren nach dem vorherigen Anspruch,
wobei das Matrixmaterial Silikon enthält oder aus Silikon besteht und die Licht reflektierenden Partikel aus Titanoxid bestehen.

3. Verfahren nach einem der vorherigen Ansprüche,
wobei
- eine Vielzahl von optoelektronischen Halbleiterchips (2) an der Oberseite (1a) des Trägers (1) angeordnet werden, wobei
- jeder Halbleiterchip (2) im Betrieb zur Erzeugung von elektromagnetischer Strahlung eines Wellenlängenbereichs mit einer dem Halbleiterchip (2) zugeordneten Peak-Wellenlänge vorgesehen ist,
- die Peak-Wellenlänge eines jeden der Halbleiterchips (2) von einem Mittelwert der Peak-Wellenlängen aller optoelektronischen Halbleiterchips (2) um höchstens +/- 2 % abweicht.

4. Verfahren nach dem vorherigen Anspruch,
wobei den optoelektronischen Halbleiterchips (2) vor oder nach dem Umformen eine gemeinsame Leuchtstoffschicht (8) an ihrer Oberseite (2a) oder ihrer Unterseite (2b) nachgeordnet wird.

5. Verfahren nach einem der vorherigen Ansprüche,
wobei
- vor oder nach dem Umformen für jeden Halbleiterchip (2) zumindest eine Durchkontaktierung (6) mit einem elektrisch leitenden Material erzeugt wird, wobei
- die Durchkontaktierung (6) lateral beabstandet zum zugeordneten Halbleiterchip (2) angeordnet ist, und
- die Durchkontaktierung (6) den Formkörper (3) vollständig durchdringt, wobei sich die Durchkontaktierung (6) von einer Oberseite (3a) des Formkörpers (3) zu einer Unterseite (3b) des Formkörpers (3) erstreckt.

6. Verfahren nach dem vorherigen Anspruch,
wobei zwischen der Durchkontaktierung (6) und dem zugeordneten Halbleiterchip (2) eine elektrisch leitende Verbindung (7) erzeugt wird, die elektrisch leitend mit der dem Träger (1) abgewandten Oberfläche an der Oberseite (2a) des Halbleiterchips (2) verbunden ist und sich an der Oberseite (3a) des Formkörpers (3) erstreckt.

7. Optoelektronisches Halbleiterbauteil mit
- einem optoelektronischen Halbleiterchip (2), dessen Seitenflächen (2c) von einem Formkörper (3) bedeckt sind,
- zumindest einer Durchkontaktierung (6), die ein elektrisch leitendes Material umfasst, und
- einer elektrisch leitenden Verbindung (7), die elektrisch leitend mit dem Halbleiterchip (2) und der Durchkontaktierung (6) verbunden ist, wobei
- die Durchkontaktierung (6) lateral beabstandet zum Halbleiterchip (1) angeordnet ist,
- die Durchkontaktierung (6) den Formkörper (3) vollständig durchdringt, wobei sich die Durchkontaktierung (6) von einer Oberseite (3a) des Formkörpers (3) zu einer Unterseite (3b) des Formkörpers (3) erstreckt,
- die elektrisch leitende Verbindung (7) sich an der Oberseite (3a) des Formkörpers (3) erstreckt, **dadurch gekennzeichnet, dass**
- der Formkörper (3) optisch reflektierend ausgebildet ist,
- die Durchkontaktierung (6) an der Oberseite (3a) und an der Unterseite (3b) des Formkörpers (3) frei zugänglich ist,
- der optoelektronische Halbleiterchip (2) nur bis zu einer bestimmten Höhe an seinen Seitenflächen (2c) vom Formkörper (3) bedeckt ist und Teile des Halbleiterchips (2) aus dem Formkörper (3) herausragen, und
- der optoelektronische Halbleiterchip (2) an seiner dem Träger (1) abgewandten Oberfläche an der Oberseite (2a) und an seiner dem Träger zugewandten Oberfläche an der Unterseite (2b) frei vom Formkörper ist.

8. Optoelektronisches Halbleiterbauteil nach dem vorherigen Anspruch,
bei dem der Formkörper (3) ein Matrixmaterial umfasst, wobei Licht reflektierende Partikel in das Matrixmaterial eingebracht sind, sodass der Formkörper (3) weiß erscheint.

9. Optoelektronisches Halbleiterbauteil nach dem vorherigen Anspruch,
bei dem das Matrixmaterial Silikon enthält oder aus Silikon besteht und die Licht reflektierenden Partikel aus Titanoxid bestehen.

10. Optoelektronisches Halbleiterbauteil nach Anspruch 7, bei dem der Formkörper (3) strahlungsdurchlässig ausgebildet ist.

11. Optoelektronisches Halbleiterbauteil nach einem der Ansprüche 7 bis 10,
mit einer Vielzahl von optoelektronischen Halbleiterchips (2), die mittels elektrisch leitender Verbindungen (7), die sich an der Oberseite (3a) des Formkörpers (3) erstrecken, elektrisch leitend miteinander verbunden sind.

## Claims

1. Method for producing an optoelectronic semiconductor component comprising the following steps:
- providing a carrier (1),
- arranging at least one optoelectronic semiconductor chip (2) at a top side (1a) of the carrier (1),
- shaping a shaped body (3) around the at least one optoelectronic semiconductor chip (2) wherein the shaped body (3) covers all side areas (2c) of the at least one optoelectronic semiconductor chip (2), and wherein the surface facing away from the carrier (1) at the top side (2a) and the surface facing the carrier at the underside (2b) of the at least one semiconductor chip (2) remains free of the shaped body (3),
- removing the carrier (1), wherein
- the shaped body (3) comprises a matrix material and light-reflecting particles are introduced into the matrix material, such that the shaped body (3) appears white
- the method steps are carried out in the specified order,
- the at least one optoelectronic semiconductor chip (2) is covered from the shaped body (3) only up to a specific height at its side areas (2c), and parts of the at least one semiconductor chip (2) protrude from the shaped body (3).

2. Method according to the preceding claim,
wherein the matrix material contains silicone or consists of silicone and the light-reflecting particles consist of titanium oxide.

3. Method according to any of the preceding claims,
wherein
- a multiplicity of optoelectronic semiconductor chips (2) are arranged at the top side (1a) of the carrier (1), wherein
- each semiconductor chip (2) is provided during operation for generating electromagnet radiation in a wavelength range having a peak wavelength assigned to the semiconductor chip (2),
- the peak wavelength of each of the semiconductor chips (2) deviates from an average value of the peak wavelengths of all the optoelectronic semiconductor chips (2) by at most +/-2%.

4. Method according to the preceding claim,
wherein a common phosphor layer (8) is disposed downstream of the optoelectronic semiconductor chips (2) at their top side (2a) or their underside (2b) before or after the shaping-around process.

5. Method according to any of the preceding claims,
wherein
- at least one plated-through hole (6) with an electrically conductive material is produced before or after the shaping-around process for each semiconductor chip (2), wherein
- the plated-through hole (6) is arranged laterally spaced apart from the assigned semiconductor chip (2), and
- the plated-through hole (6) completely penetrates through the shaped body (3), wherein the plated-through hole (6) extends from a top side (3a) of the shaped body (3) to an underside (3b) of the shaped body (3).

6. Method according to the preceding claim,
wherein an electrically conductive connection (7) is produced between the plated-through hole (6) and the assigned semiconductor chip (2), which connection is electrically conductively connected to the surface facing away from the carrier (1) at the top side (2a) of the semiconductor chip (2) and extends at the top side (3a) of the shaped body (3).

7. Optoelectronic semiconductor component comprising
- an optoelectronic semiconductor chip (2), the side areas (2c) of which are covered by a shaped body (3),
- at least one plated-through hole (6) comprising an electrically conductive material, and
- an electrically conductive connection (7), which is electrically conductively connected to the semiconductor chip (2) and the plated-through hole (6), wherein,
- the plated-through hole (6) is arranged laterally spaced apart from the semiconductor chip (2),
- the plated-through hole (6) completely penetrates through the shaped body (3), wherein the plated-through hole (6) extends from a top side (3a) of the shaped body (3) to an underside (3b) of the shaped body (3),
- the electrically conductive connection (7) extends at the top side (3a) of the shaped body (3), **characterized in that**
- the shaped body (3) is embodied such that it is optically reflective
- the plated-through hole (6) on the top side (3a) and on the underside (3b) of the shaped body (3) is freely accessible,
- the optoelectronic semiconductor chip (2) is covered from the shaped body (3) only up to a specific height at its side areas (2c), and parts of the at least one semiconductor chip (2) protrude from the shaped body (3), and
- the surface facing away from the carrier (1) at the top side (2a) and the surface facing the carrier at the underside (2b) of the at least one semiconductor chip (2) is free of the shaped body (3).

8. Optoelectronic semiconductor component according to the preceding claim,
in which the shaped body (3) comprises a matrix material, wherein light-reflecting particles are introduced into the matrix material, such that the shaped body (3) appears white.

9. Optoelectronic semiconductor component according to the preceding claim,
in which the matrix material contains silicone or consists of silicone and the light-reflecting particles consist of titanium oxide.

10. Optoelectronic semiconductor component according to claim 7,
in which the shaped body (3) is embodied such that it is radiation-transmissive.

11. Optoelectronic semiconductor component according to any of the preceding claims 7 to 10,
comprising a multiplicity of optoelectronic semiconductor chips (2), which are electrically conductively connected to one another by means of electrically conductive connections (7) extending at the top side (3a) of the shaped body (3).

## Revendications

1. Procédé de fabrication d'un composant semi-conducteur optoélectronique, comprenant les étapes suivantes:
- mise à disposition d'un support (1),
- disposition d'au moins une puce semi-conductrice optoélectronique (2) sur une face supérieure (1a) du support (1),
- constitution de l'au moins une puce semi-conductrice optoélectronique (2) à l'aide d'un corps moulé (3), le corps moulé (3) recouvrant toutes les surfaces latérales (2c) de l'au moins une puce semi-conductrice optoélectronique (2) et la surface de la face supérieure (2a) opposée au support (1) et la surface de la face inférieure (2b) de l'au moins une puce semi-conductrice (2) faisant face au support reste exempte du corps moulé (3),
- rétraction du support (1),
- le corps moulé (3) comprenant un matériau de matrice, et des particules réfléchissant la lumière étant incorporées dans le matériau de matrice de manière que le corps moulé (3) présente une apparence blanche,
- les étapes du procédé étant réalisées dans l'ordre indiqué, et
- l'au moins une puce semi-conductrice optoélectronique (2) n'est couverte par le corps moulé (3) que jusqu'à une certaine hauteur à ses faces latérales (2c) et des parties de l'au moins une puce semi-conductrice (2) font saillie du corps moulé (3).

2. Procédé selon la revendication précédente,
dans lequel le matériau de matrice contient du silicone ou consiste en silicone et les particules réfléchissant la lumière consistent en oxyde de titane.

3. Procédé selon l'une des revendications précédentes, dans lequel
- une pluralité de puces semi-conductrices optoélectroniques (2) sont disposées sur la face supérieure (1a) du support (1),
- chaque puce semi-conductrice (2) étant conçue pour générer en service un rayonnement électromagnétique d'une gamme de longueurs d'onde à une longueur d'onde de crête affectée à la puce semi-conductrice (2),
- la longueur d'onde de crête de chacune des puces semi-conductrices (2) diffère d'au plus +/- 2% d'une moyenne des longueurs d'onde de crête de la totalité des puces semi-conductrices optoélectroniques (2).

4. Procédé selon la revendication précédente,
dans lequel avant ou après le formage, on dispose, en aval, une couche fluorescente commune (8) sur la face supérieure (2a) ou la face inférieure (2b) des puces semi-conductrices optoélectroniques (2).

5. Procédé selon l'une des revendications précédentes, dans lequel
- avant ou après le formage, on crée au moins un via (6) pour chaque puce semi-conductrice (2) à l'aide d'un matériau électriquement conducteur,
- le via (6) étant disposé de façon latéralement espacée de la puce semi-conductrice associée (2), et
- le via (6) traverse entièrement le corps moulé (3), le via (6) s'étendant d'une face supérieure (3a) du corps moulé (3) vers une face inférieure (3b) du corps moulé (3).

6. Procédé selon la revendication précédente,
dans lequel entre le via (6) et la puce semi-conductrice (2) associée, une liaison électriquement conductrice (7) est créée qui est reliée de manière l'électriquement conductrice à la surface de la face supérieure (2a) opposée au support (1) de la puce semi-conductrice (2) et s'étendant à la face supérieure (3a) du corps moulé (3).

7. Composant à semi-conducteur optoélectronique comprenant
- une puce semi-conductrice optoélectronique (2) dont les surfaces latérales (2c) sont recouvertes d'un corps moulé(3),
- au moins un via (6) comportant un matériau électriquement conducteur, et
- une liaison électriquement conductrice (7) reliée de façon électriquement conductrice à la puce semi-conductrice (2) et au via (6),
- le via (6) étant disposé de façon latéralement espacée de la puce semi-conductrice (1),
- le via (6) traverse entièrement le corps de moule (3), le via (6) s'étendant d'une face supérieure (3a) du corps moulé (3) vers une face inférieure (3b) du corps moulé (3),
- la liaison électriquement conductrice (7) s'étend à la face supérieure (3a) du corps moulé (3), **caractérisé en ce que**
- le corps moulé (3) est du type réfléchissant optiquement,
- le via (6) prévu à la face supérieure (3a) et à la face inférieure (3b) du corps moulé(3) est librement accessible,
- la puce semi-conductrice optoélectronique (2) n'est couverte par le corps moulé (3) que jusqu'à une certaine hauteur sur ses faces latérales (2c) et des parties de la puce semi-conductrice (2) font saillie du corps moulé(3), et
- la puce semi-conductrice optoélectronique (2) reste, à sa surface de la face supérieure (2a) opposée au support (1) et à sa surface de la face inférieure (2b) faisant face au support exempte du corps moulé (3).

8. Composant à semi-conducteur optoélectronique selon la revendication précédente,
dans lequel le corps moulé (3) comprend un matériau de matrice, des particules réfléchissant la lumière étant incorporées dans le matériau de matrice de manière que le corps moulé (3) présente une apparence blanche.

9. Composant à semi-conducteur optoélectronique selon la revendication précédente,
dans lequel le matériau de matrice contient du silicone ou consiste en silicone et les particules réfléchissant la lumière consistent en oxyde de titane.

10. Composant à semi-conducteur optoélectronique selon la revendication 7,
dans lequel le corps moulé (3) est perméable à la radiation.

11. Composant à semi-conducteur optoélectronique selon l'une des revendications 7 à 10,
comprenant une multitude de puces semi-conductrices optoélectroniques (2) reliées entre elles de manière électriquement conductrice au moyen de connexions électriquement conductrices (7) s'étendant à la face supérieure (3a) du corps moulé (3).
